## Europäisches Patentamt
## European Patent Office
## Office européen des brevets

(19)

(11) **EP 0 591 675 B1**

(12) **EUROPÄISCHE PATENTSCHRIFT**

(45) Veröffentlichungstag und Bekanntmachung des Hinweises auf die Patenterteilung:
   **24.07.1996  Patentblatt 1996/30**

(51) Int Cl.6: **H01J 37/34**

(21) Anmeldenummer: **93113713.7**

(22) Anmeldetag: **27.08.1993**

(54) **Einrichtung für die Verhinderung von Überschlägen in Vakuum-Zerstäubungsanlagen**

Device for avoiding arcing in vacuum sputtering apparatuses

Dispositif permettant d'éviter les décharges en arc dans les installations de pulvérisation sous vide

(84) Benannte Vertragsstaaten:
   **BE DE ES FR LU NL**

(30) Priorität: **07.10.1992  DE 4233720**

(43) Veröffentlichungstag der Anmeldung:
   **13.04.1994  Patentblatt 1994/15**

(73) Patentinhaber: **LEYBOLD AKTIENGESELLSCHAFT**
   **D-63450 Hanau (DE)**

(72) Erfinder:
   • **Stürmer, Johann**
     **D-63579 Freigericht (DE)**
   • **Lübbehusen, Michael, Dr.**
     **D-63486 Bruchköbel (DE)**
   • **Thorn, Gernot, Dipl.-Ing.**
     **D-63454 Hanau (DE)**

(74) Vertreter: **Schickedanz, Willi, Dipl.-Ing.**
   **Langener Strasse 68**
   **D-63073 Offenbach (DE)**

(56) Entgegenhaltungen:
   **US-A- 4 464 223        US-A- 4 693 805**
   **US-A- 5 015 493        US-A- 5 126 033**
   **US-A- 5 300 205**

   • **IBM Technical Disclosure Bulletin, Band 17, Teil 7, Dezember 1974, Seiten 2172,2173.**

**Beschreibung**

Die Erfindung betrifft eine Einrichtung nach dem Oberbegriff des Patentanspruchs 1.

Bei Zerstäubungs- oder Sputteranlagen, in denen ein Target einer Kathode durch auftreffende Ionen zerstäubt wird, damit sich die zerstäubten Target-Teilchen direkt oder nach vorheriger chemischer Vereinigung mit anderen Teilchen auf einem Substrat niederschlagen, stellt man häufig Überschläge fest. Diese Überschläge finden in der Regel zwischen Kathode und Anode statt; es können jedoch auch Überschläge zwischen den Elektroden und anderen Teilen der Anlage auftreten. Besonders häufig kommen Überschläge beim reaktiven Zerstäuben von Metalloxiden bzw. Metallnitriden vor. Dies hat seinen Grund darin, daß die Entstehung von mehr oder weniger gut isolierenden Schichten auf der Targetoberfläche nicht vermieden werden kann, die ihrerseits mit der Targetoberfläche kleine Kondensatoren bilden. Da diese Schichten mit dem Plasma in Verbindung stehen, laden sie sich auf und erzeugen schließlich eine derart hohe elektrische Feldstärke, daß es zum Durchbruch kommt, der eine Bogenentladung zwischen Kathode und Anode zur Folge hat. Hieraus resultieren punktuelle Zerstörungen des Targets und damit Schichtdefekte auf dem Substrat.

Um derartige Überschläge zu veimeiden, wurde bereits vorgeschlagen, eine Gleichstrom-Magnetkathode, die an eine Gleichstromquelle angeschlossen ist, mit Hilfe einer angepaßten, zusätzlichen Schaltung periodisch für kurze Zeitspannen auf positives Potential zu bringen, wobei die Frequenz des periodischen Umpolens in Abhängigkeit von der abzuscheidenden Schicht einstellbar ist (deutsche Patentanmeldung 42 02 425.0). Das Umpolen wird mit Hilfe von vier Schaltern durchgeführt, von denen zwei eine Verbindung zwischen einer Spannungsquelle und der Kathode der Anlage und zwei eine Verbindung zwischen dieser Spannungsquelle und der Anode dieser Anlage herstellen können. Als Schalter können hierbei Thyristoren eingesetzt werden, die jedoch eine relativ komplizierte Ansteuerung erfordern.

Es ist weiterhin ein Verfahren und eine Vorrichtung zum schonenden Beschichten elektrisch leitender Gegenstände mittels Plasma bekannt, bei dem die elektrische Energie mit periodisch wiederholten Gleichstromimpulsen zugeführt wird (Deutsches Patent Hr. 37 00 633). Für die Beschichtung elektrisch nichtleitender Substrate ist dieses Verfahren nicht geeignet.

Der Erfindung liegt deshalb die Aufgabe zugrunde, die Umpolung einer Elektrode in einer Gleichstrom-Zerstäubungsanlage, in der auch elektrisch nicht-leitende Substrate beschichtet oder geätzt werden können, zu vereinfachen.

Diese Aufgabe wird gemäß den Merkmalen des Patentanspruchs 1 gelöst.

Der mit der Erfindung erzielte Vorteil besteht insbesondere darin, daß das substratunabhängige interne Arcing unterdrückt wird. Die das Plasma speisende, d. h. energiezuführende Stromversorgung ist nicht gepulst, sondern eine Gleichstromversorgung. Eine solche Stromversorgung ist einfach und billig, da der aufwendige Schalter entfällt, der bei Impulsbetrieb notwendig ist. Die beim "internen Arcing" benutzte Impulsstromquelle führt dem Plasma keine Energie zu. Sie führt vielmehr aufgrund ihrer entgegengesetzten Polung zur Unterbrechung des Beschichtungsprozesses.

Ein Ausführungsbeispiel der Erfindung ist in der Zeichnung dargestellt und wird im folgenden näher beschrieben. Es zeigen:

Fig. 1    eine Prinzipdarstellung einer Gleichstrom-Sputteranlage mit einer erfindungsgemäßen Einrichtung zum Verhindern von Überschlägen;

Fig. 2    eine Prinzip-Darstellung zweier sich überlagernder Kathoden-Potentiale;

Fig. 3    eine resultierende Kathodenspannung;

Fig. 4    eine Pulsgenerator-Steuerung für eine Kathode.

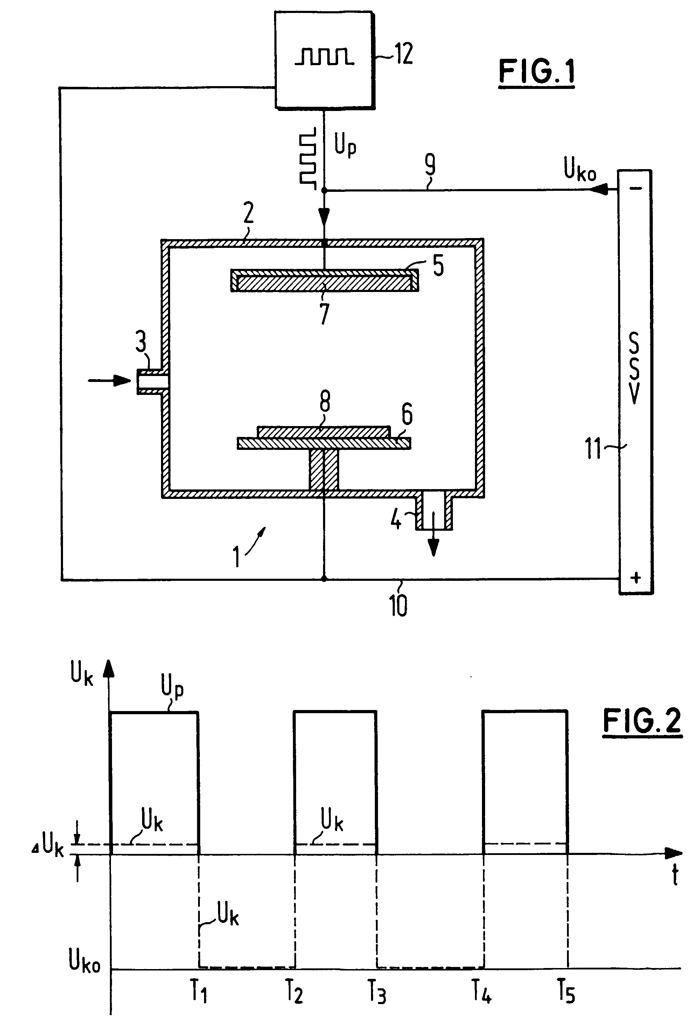

In der Fig. 1 ist eine Zerstäubungs- oder Sputteranlage 1 dargestellt, die ein Gehäuse 2 aufweist, das mit einem Gaseinlaßstutzen 3 und einem Gasauslaßstutzen 4 versehen ist. In dem Gehäuse 2 liegen sich eine Kathode 5 und eine Anode 6 gegenüber. Die Kathode 5 ist topfförmig ausgebildet und umfaßt ein Target 7, aus dem während des Betriebs Teilchen herausgeschlagen werden. Auf der Anode 6, die als Drehteller ausgebildet sein kann, befindet sich ein Substrat 8, das durch das Plasma behandelt wird, welches sich zwischen Anode und Kathode ausbildet. Die Behandlung kann darin bestehen, daß das Substrat 8 aus dem Plasma heraus beschichtet oder geätzt wird. Die Kathode 5 ist über eine Leitung 9 an das negative Potential einer Stromversorgung 11 angeschlossen, während die Anode über eine Leitung 10 an dem positiven Potential dieser Stromversorgung 11 liegt.

Die Kathode 5 ist außerdem noch mit einer Impulsstromquelle 12 verbunden, deren Ausgangspotential sich dem negativen Potential der Stromversorgung 11 überlagert. Das Ausgangspotential der negativen Stromversorgung 11 ist beispielsweise $U_{KO} = -500$ Volt, während das Potential der Impulsstromquelle 12 etwa $U_P = +510...600$ Volt beträgt, so daß sich ein $\Delta U_K$ von ca. $+10...100$ Volt ergibt.

In der Fig. 2 ist näher dargestellt, wie der Potentialverlauf an der Kathode 5 ist. Dem negativen Gleichspannungspotential $U_{KO}$ der Stromversorgung 11 ist eine impulsförmige Spannung $U_P$ aus der Impulsstromquelle 12 überlagert. Diese impulsförmige Spannung $U_P$ ist oberhalb der t-Achse so dargestellt, wie sie aus der Impulsstromquelle 12 kommt, d.h. ohne Überlagerung. Die resultierende Kathodenspannung $U_K$ ist in der Fig. 2 gestrichelt dargestellt. Man erkennt hieraus, daß das an sich negative Potential der Stromversorgung 11 an der Kathode 5 von Zeit zu Zeit auf positives Potential gebracht wird. So steht z.B. während der Zeit $T_1$ - $T_2$ an der Kathode 5 negatives Potential $U_{KO}$ an, um dann zwischen $T_2$ und $T_3$ auf positivem Potential zu liegen. Die impulsförmigen Spannungen aus der Impulsstromquelle 12 haben eine positive Amplitude, die um einen Betrag $\Delta U_K$ größer sind als die negative Amplitude der Gleichspannung $U_{KO}$. Hierdurch ergibt sich während der Zeit $T_2$ bis $T_3$ eine insgesamt positive Spannung von der Größe $\Delta U_K$ an der Kathode 5. Durch diese Spannung findet eine Entladung der erwähnten kleinen Kondensatoren am Target statt, so daß ein Durchbruch dieser Kondensatoren und damit auch ein Überschlag verhindert wird.

Die Lage eines Impulses, z. B. $T_3$ - $T_2$, beträgt z. B. weniger als 100 μs, während die Zeit zwischen zwei Impulsen das 100- bis 1000fache hiervon beträgt.

Die Breite und Abstände der Impulse aus der Impulsstromquelle 12 können beliebig gewählt werden.

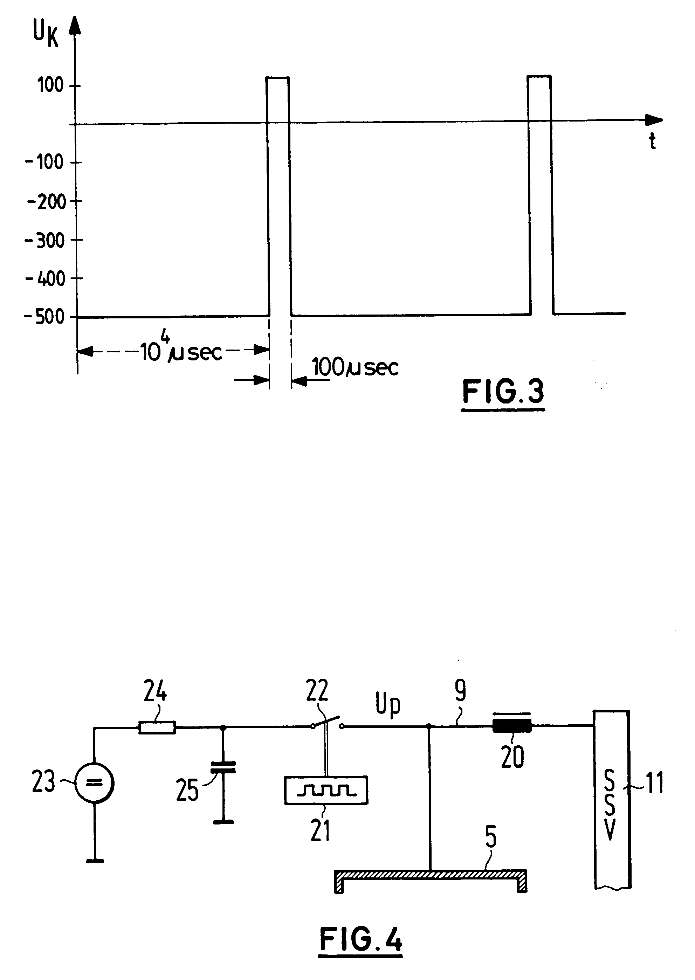

In der Fig. 3 ist noch einmal die überlagerte Kathodenspannung $U_K$ mit konkreten Zeit- und Amplitudenwerten dargestellt. Man erkennt hierbei deutlich, daß die positiven Spannungsimpulse nur für eine relativ kurze Zeit auftreten.

Die Fig. 4 zeigt nähere Einzelheiten über die Impulssteuerung. Zwischen der Stromversorgung 11 und der Kathode 5 ist hierbei eine Drossel 20 geschaltet, welche u.a. eine Strombegrenzung bewirkt. Der Impulsgeber selbst ist als Steuerung 21 ausgebildet, die einen Schalter 22 in einem vorgegebenen Takt schließt und öffnet und hierbei die Spannung einer Gleichspannungsquelle 23 über einen Widerstand 24 auf die Elektrode 5 gibt bzw. von dieser fernhält. Es versteht sich, daß die Steuerung 21 so ausgelegt sein kann, daß sich das Impuls-Taktverhältnis beliebig einstellen läßt. Ein Kondensator parallel zur Spannungsquelle 23 ist so ausgelegt, daß er eine Spannung mit der benötigten Amplitude liefert. Der Schalter 22 kann als Röhre, Thyristor oder Transistor realisiert sein.

Die Auslegung der Anordnung erfolgt derart, daß ein Strom von der Größe des Kathodenstroms über die gewünschte Pulszeit aus dem Kondensator 25 getrieben werden kann, z. B. beträgt der Kathodenstrom $I_K$ = -50 A bei einem $\Delta U_K$ von 100 Volt und einer Pulsdauer von 10 μs. Die Kapazität des Kondensators 25 berechnet sich somit aus

$$i_O = C * du_O / dt \quad \text{oder} \quad C = i_O \, dt / du_O$$

zu

$$C = 50\,A * 10^{-5}\,s / 100\,V = 5\,\mu F.$$

**Patentansprüche**

1. Einrichtung für die Verhinderung von Überschlägen in Vakuum-Zerstäubungsanlagen, mit

    a) einer Kathode (5);

    b) einer ersten Gleichspannungsquelle (11), deren negatives Potential an der Kathode (5) liegt und eine vorgegebene Größe hat;
    c) einer Anordnung, welche die Kathode (5) für vorgegebene Zeitabschnitte auf positives Potential ($\Delta U_K$) anhebt;
    **gekennzeichnet durch**
    d) eine Induktivität (20), die zwischen der ersten Gleichspannungsquelle (11) und der Kathode (5) angeordnet ist;
    e) eine zweite Gleichspannungsquelle (23), deren positive Elektrode mit der Kathode (5) verbunden ist und deren positives Potential größer als das negative Potential der ersten Gleichspannungsquelle (11) ist;
    f) einen Kondensator (25), der parallel zur zweiten Gleichspannungsquelle (23) liegt;
    g) einen steuerbaren Schalter (22) zwischen der positiven Elektrode der zweiten Gleichspannungsquelle (23) und dem Kondensator (25) auf der einen Seite und der Kathode (5) auf der anderen Seite;
    f) eine Pulserzeugerschaltung (21), die den Schalter (22) öffnet und schließt

2. Einrichtung nach Anspruch 1, **dadurch gekennzeichnet**, daß der Kondensator (25) eine positive Spannung aufweisen kann, die größer als das negative Potential der ersten Gleichspannungsquelle (11) ist.

3. Einrichtung nach Anspruch 1, **dadurch gekennzeichnet**, daß der Kondensator (25) eine Kapazität hat, die sich aus der Gleichung $C = i_0 dt / du_0$ berechnet, wobei $i_0$ der Kathodenstrom bedeutet, $dt$ die Impulszeit ist, während welcher der Schalter (22) periodisch geschlossen ist und wobei $du_0$ die Größe von $\Delta U_K$ ist.

4. Einrichtung nach Anspruch 1, **dadurch gekennzeichnet**, daß ein Kondensator (25) eine positive und eine negative Seite aufweist und daß die negative Seite mit Erde verbunden ist, wobei der steuerbare Schalter (22) zwischen der positiven Seite des Kondensators (25) und der Kathode (5) liegt.

5. Einrichtung nach Anspruch 1, **dadurch gekennzeichnet**, daß der steuerbare Schalter ein GTO-Thyristor ist.

6. Einrichtung nach Anspruch 3, **dadurch gekennzeichnet**, daß die Kapazität des Kondensators (25) etwa 5 μF beträgt.

**Claims**

1. A device for preventing flashovers in vacuum sputter installations, having

a) a cathode (5);
b) a first direct current voltage source (11) whereof the negative potential is applied across the cathode (5) and has a predetermined magnitude;
c) an arrangement which raises the cathode (5) for predetermined time periods to a positive potential ($\Delta U_K$);
characterised by
d) an inductor (20) which is arranged between the first direct current voltage source (11) and the cathode (5);
e) a second direct current voltage source (23) whereof the positive electrode is connected to the cathode (5) and whereof the positive potential is greater than the negative potential of the first direct current voltage source (11);
f) a capacitor (25) which is in parallel with the second direct current voltage source (23);
g) a controllable switch (22) between the positive electrode of the second direct current voltage source (23) and the capacitor (25) on the one side and the cathode (5) on the other side;
h) a pulse generating circuit (21) which opens and closes the switch (22).

2. A device according to Claim 1, characterised in that the capacitor (25) can have a positive voltage which is greater than the negative potential of the first direct current voltage source (11).

3. A device according to Claim 1, characterised in that the capacitor (25) has a capacitance which is calculated from the equation $C = i_o dt / du_o$, where $i_o$ denotes the cathode current, dt is the pulse time during which the switch (22) is periodically closed, and where $du_o$ is the magnitude of $\Delta U_K$.

4. A device according to Claim 1, characterised in that a capacitor (25) has a positive and a negative side and in that the negative side is connected to earth, the controllable switch (22) being between the positive side of the capacitor (25) and the cathode (5).

5. A device according to Claim 1, characterised in that the controllable switch is a GTO thyristor.

6. A device according to Claim 3, characterised in that the capacitance of the capacitor (25) is approximately 5 $\mu$F.

**Revendications**

1. Dispositif destiné à empêcher des décharges dans des installations de pulvérisation sous vide, comportant

a) une cathode (5) ;
b) une première source de tension continue (11) dont le potentiel négatif est relié à la cathode (5) et possède une grandeur donnée ;
c) un dispositif qui relève la cathode (5) pendant des intervalles de temps donnés à un potentiel positif ($\Delta U_K$) ;

caractérisé par

d) une inductivité (20) qui est placée entre la première source de tension continue (11) et la cathode (5) ;
e) une deuxième source de tension continue (23) dont l'électrode positive est reliée à la cathode (5) et dont le potentiel positif est supérieur au potentiel négatif de la première source de tension continue (11) ;
f) un condensateur (25) qui est parallèle à la deuxième source de tension continue (23) ;
g) un interrupteur (22) commandable entre l'électrode positive de la deuxième source de tension continue (23) et le condensateur (25) sur un côté et la cathode (5) sur l'autre côté ;
f) un circuit de génération d'impulsions (21) qui ouvre et ferme l'interrupteur (22).

2. Dispositif selon la revendication 1, caractérisé en ce que le condensateur (25) peut présenter une tension positive, qui est supérieure au potentiel négatif de la première source de tension continue (11).

3. Dispositif selon la revendication 1, caractérisé en ce que le condensateur (25) possède une capacité qui se calcule à partir de l'équation $C = i_0 dt/du_0$, $i_0$ signifiant le courant de la cathode, dt le temps d'impulsion pendant lequel l'interrupteur (22) est périodiquement fermé et $du_0$ étant la grandeur de $\Delta U_K$.

4. Dispositif selon la revendication 1, caractérisé en ce qu'un condensateur (25) présente un côté positif et un côté négatif et en ce que le côté négatif est relié à la terre, l'interrupteur (22) commandable se trouvant entre le côté positif du condensateur (25) et la cathode (5).

5. Dispositif selon la revendication 1, caractérisé en ce que l'interrupteur commandable est un thyristor GTO.

6. Dispositif selon la revendication 3, caractérisé en ce que la capacité du condensateur (25) est environ égale à 5 $\mu$F.

FIG.1

FIG.2

$U_K$

100

-100

-200

-300

-400

-500

t

$10^4 \mu sec$

$100 \mu sec$

**FIG.3**

24

22

$U_p$

9

20

23

25

21

5

S S V

11

**FIG.4**